Europäisches Patentamt

European Patent Office

Office européen des brevets

(11) Numéro de publication: **0 360 327**
**A1**

## DEMANDE DE BREVET EUROPEEN

(21) Numéro de dépôt: 89202283.1

(22) Date de dépôt: **11.09.89**

(51) Int. Cl.⁵: **F16K 13/10 , F16K 15/00 , C30B 25/14**

(30) Priorité: **16.09.88 FR 8812104**

(43) Date de publication de la demande:
**28.03.90 Bulletin 90/13**

(84) Etats contractants désignés:
**DE FR GB IT**

(71) Demandeur: **LABORATOIRES D'ELECTRONIQUE PHILIPS**
**1, Avenue Descartes**
**F-94450 Limeil Brévannes(FR)**

(84) **FR**

Demandeur: **N.V. Philips' Gloeilampenfabrieken**
**Groenewoudseweg 1**
**NL-5621 BA Eindhoven(NL)**

(84) **DE GB IT**

(72) Inventeur: **Frijlink, Peter**
**Societe Civile S.P.I.D. 209 rue de L'Université**
**F-75007 Paris(FR)**

(74) Mandataire: **Caron, Jean et al**
**SOCIETE CIVILE S.P.I.D. 209, rue de l'Université**
**F-75007 Paris(FR)**

(54) **Système antiretour de fluide à débit continu.**

(57) Système antiretour de fluide du type comportant un tube débouchant dans un liquide, mais où l'on a cherché à éviter la production de bulles. Selon l'invention le dispositif comporte une enceinte remplie d'un liquide (6),munie d'une paroi (4) possédant un bord libre inférieur (5) qui plonge dans le liquide plus profondément que l'extémité du tube d'arrivée (3). Les deux volumes (1 et 2) séparés par la paroi (4) sont reliés par un tube (8) muni d'un étranglement (7) qui crée une dépression faisant descendre le liquide en dessous de l'extrémité du tube d'arrivée (3).

Application notamment à l'équipement de four d'épitaxie entre la sortie des gaz et un dispositif de lavage des gaz.

FIG. 1

EP 0 360 327 A1

## Système antiretour de fluide à débit continu.

La présente invention concerne un système antiretour de fluide comportant un dispositif constitué par une enceinte contenant un liquide inerte vis à vis dudit fluide, un tube d'arrivée de fluide dont l'extrémité, en l'absence de débit de fluide, plonge dans le liquide, et un tube de départ de fluide puisant le fluide dans l'enceinte au-dessus du niveau du liquide.

Les dispositifs antiretour à liquide correspondant au préambule ci-dessus sont bien connus. Ils sont basés sur le fait que, grâce à la différence de section importante entre le tube d'arrivée et l'enceinte, le passage d'un gaz du tube d'arrivée vers l'enceinte au travers du liquide sous forme de bulles est possible sous faible pression, alors qu'une pression en sens inverse ferait monter le liquide assez haut dans le tube d'arrivée pour créer une contre pression importante.

Néanmoins, dans ces dispositifs, le passage du gaz se fait au moyen de bulles, c'est-à-dire de façon saccadée, et ceci présente des inconvénients, notamment en induisant des sauts de pression irréguliers et importants dans la colonne de gaz aussi bien en aval qu'en amont du dispositif. En outre le brassage du liquide par le gaz n'est pas toujours souhaitable.

Un tel système est utilisé notamment dans des installations pour la fabrication de semiconducteur par épitaxie en phase gazeuse. Dans ces installations, on emploie des gaz réactants contenant des hydrures toxiques. A la sortie du réacteur d'épitaxie, il reste des hydrures non utilisés dans le gaz d'échappement, et on nettoie ce dernier en l'amenant dans une colonne de lavage où il croise des jets de liquide contenant par exemple des bromates, cas dans lequel il y a dégagement de brome, qui pourrait remonter dans les canalisations vers le réacteur avec des effets très destructeurs. On place donc un système antiretour sur la canalisation allant du réacteur vers la colonne de lavage. S'il a des irrégularités de pression en amont de ce système, cela provoque des irrégularités dans la composition du gaz réactant au contact des plaquettes de semiconducteur en cours de traitement dans le réacteur, et on observe alors des défauts d'homogénéité sur ces plaquettes.

Le but de l'invention est donc d'obtenir un débit continu et régulier du fluide.

Ce résultat est atteint du fait que l'enceinte est munie d'une paroi interne possédant un bord libre inférieur qui plonge dans le liquide plus profondément que l'extrémité du tube d'arrivée, et sépare ainsi deux volumes tels que le premier contient l'extrémité du tube d'arrivée alors que le second en est séparé par la paroi, que ces deux volumes communiquent entre eux via un organe provoquant une perte de charge lors d'un débit de fluide, et que le tube de sortie communique directement avec le second volume, de façon que, pour un débit approprié de fluide, le niveau du liquide descende dans le premier volume en-dessous de l'extrémité du tube d'arrivée, tout en restant au-dessus du bord libre de la paroi.

La différence de niveau de liquide entre les deux volumes dépend de la perte de charge et donc du débit du fluide. Il est donc avantageux, dans le cas où ce débit n'est pas constant, de prévoir une possibilité du réglage de la perte de charge.

A titre de précaution ultime, pour éviter la pollution du second volume par un retour de gaz dans le cas où le débit de fluide s'annulerait, le tube de sortie est muni d'une prise pour y injecter un gaz neutre.

Dans le cas d'utilisation de ce système entre la sortie d'un four d'épitaxie et l'entrée d'une colonne de lavage, l'enceinte et la paroi sont avantageusement faites en verre pyrex et le liquide est de l'huile de vaseline.

Il arrive que l'orifice d'entrée de la colonne de lavage s'encrasse et finisse par se boucher. Afin d'éviter tout problème dans ce cas avec le système antiretour, ce dernier comporte en aval dudit dispositif un deuxième dispositif, constitué par une enceinte contenant un liquide inerte vis à vis dudit fluide, avec un tube d'arrivée de fluide dont l'extrémité est située juste au dessus de la surface du liquide, enceinte munie d'une paroi interne possédant un bord libre inférieur qui plonge dans le liquide et sépare ainsi deux volumes tels que le premier contient l'extrémité du tube d'arrivée alors que le second en est séparé par la paroi, le premier volume étant mis en communication avec la colonne de lavage, alors que le deuxième volume est mis en communication avec l'air libre extérieur.

La description qui va suivre, en regard des dessins annexés décrivant des exemples non limitatifs fera bien comprendre comment l'invention peut être réalisée.

La figure 1 représente en coupe un système antiretour selon l'invention.

La figure 2 représente très schématiquement cinq variantes de réalisation d'un dispositif utilisé dans l'invention.

Le dispositif décrit ici à titre d'exemple est utilisé à la sortie d'un réacteur d'épitaxie industriel, dont les gaz d'échappement sont lavés dans une colonne de lavage avec production de vapeur de brome qui risque de remonter vers le réacteur en cas de coupure du flux du gaz d'échappement.

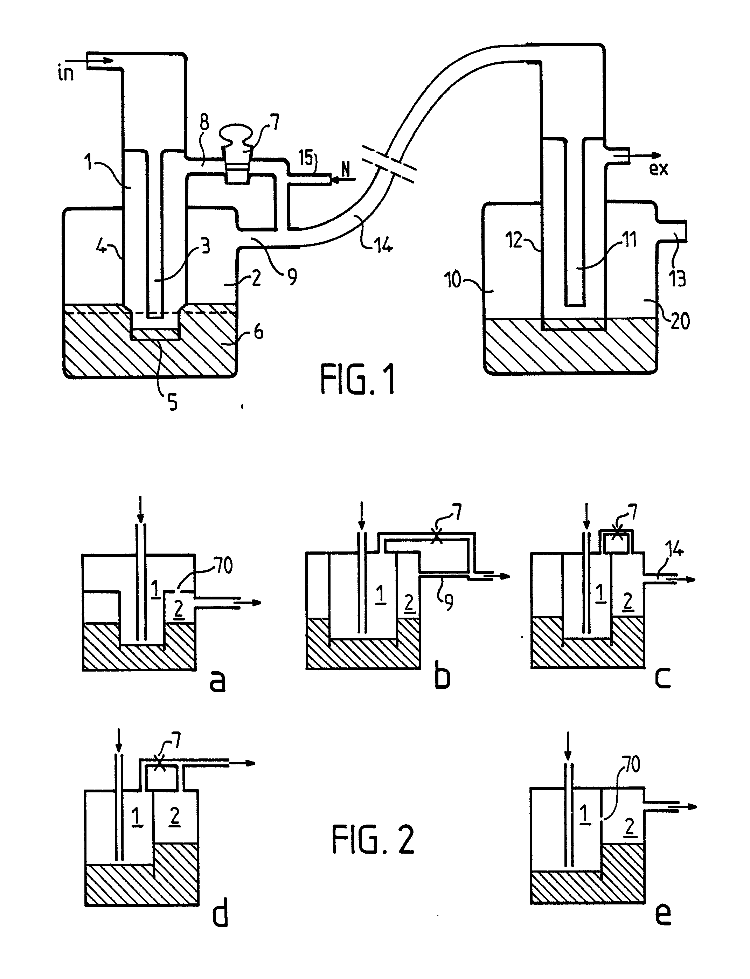

Le dispositif principal est représenté à gauche sur la figure 1. Il comporte une enceinte sensiblement cylindrique contenant un liquide 6, qui est ici de l'huile de vaseline. Le fluide mentionné plus haut est constitué ici par les gaz d'échappement du réacteur qui entrent à la partie supérieure par l'orifice référencé "in", et aboutissent dans l'enceinte par un tube d'arrivée de fluide 3. En l'absence de débit la hauteur de la surface du liquide est indiquée par la ligne en pointillé sur le dessin. Le tube d'arrivée 3 plonge alors dans le liquide.

Un ajutage 9 relié à un tube de départ de fluide 14 puise les gaz dans l'enceinte au-dessus du liquide 6.

Une paroi interne 4 possédant un bord libre inférieur 5 plonge dans le liquide 6. Le bord libre 5 est situé plus bas que l'orifice du tube d'amenée de gaz 3. Cette paroi 4 est sensiblement cylindrique et entoure le tube 3; elle sépare ainsi deux volumes 1, 2 tels que le volume 1 contient l'extrémité du tube d'arrivée 3 alors que le volume 2 en est séparé par la paroi 4.

Un tube 8 débouchant dans le volume 1 est relié à l'ajutage 9 et donc volume 2. Sur ce tube est inséré un robinet 7 qui est normalement à demi fermé pour restreindre la section de passage.

L'enceinte, la paroi 4, le tube 3, l'ajutage 9, le tube 8 et le robinet 7 sont tous réalisés ici en verre pyrex.

En régime permanent le gaz qui entre en "in" passe successivement par le tube 3, le volume 1, le tube 8 et le robinet 7 et enfin est évacué par le tube 14.

La perte de charge introduite par le robinet 7 crée une différence de pression entre le volume 1 et le volume 2, ce qui entraîne que le liquide monte dans le volume 2 et descend dans le volume 1, libérant l'extrémité du tube 3 et évitant ainsi la production de bulles. Le liquide a alors la position indiquée par des hachures sur le dessin, sa surface étant indiquée par une ligne continue.

Aucun débit ne passe dans l'ajutage 9 puisque le volume 2 est fermé à sa partie inférieure par le liquide 6. La perte de charge doit être telle qu'elle crée une différence de hauteur appropriée. Donc si le débit de fluide est variable, la perte de charge doit être ajustée en fonction de ce débit pour avoir toujours une différence de hauteur correcte. Par contre dans le cas où le débit est fixé et permanent, la perte de charge peut être fixe, par exemple provoquée par un simple gicleur calibré. Inversement dans le cas d'installation de production de gros volume où un investissement plus élevé est justifié, le dispositif 7 peut être un détendeur procurant une différence de pression maintenue automatiquement constante.

Bien entendu beaucoup de variantes de réalisation sont possibles et ne sortent pas du cadre de l'invention. Cinq d'entre elles sont indiquées à la figure 2. Les représentations y sont très schématiques, mais néanmoins suffisantes pour que l'homme du métier comprenne comment elles sont réalisées. Les volumes 1, 2 sont indiqués sur chaque dessin.

Les variantes a, b, c présentent une enceinte sensiblement cylindrique, et la paroi est également cylindrique et entoure le tube d'arrivée. Dans la variante a, la perte de charge est réalisée par un trou calibré 70 entre les volumes 1 et 2. La variante b est très voisine de celle de la figure 1, sauf que le tube 9 est très fin puisque aucun débit n'y est prévu. Dans la variante e, le tube 14 débouche directement dans le volume 2 indépendamment de l'organe 7 créant une perte de charge.

Les variantes d et e ont une enceinte de section horizontale rectangulaire avec une paroi interne plane reliant deux faces de l'enceinte situées en vis à vis. Dans la variante d, la perte de charge 7 est agencée sensiblement comme celle de la figure 1 et dans la variante e elle est constituée par un trou calibré 70 et le tube de départ est directement branché sur le volume 2.

Sur la figure 1, un ajutage 15 est relié au tube 8 du côté du robinet relié à la sortie des gaz 14. Par cet ajutage est introduit un gaz neutre (par exemple de l'azote, de l'argon, de l'hélium, de l'hydrogène) avec un débit réduit, mais néanmoins suffisant pour que, lorsqu'on arrête le réacteur et le débit de gaz principal, le petit débit de ce gaz neutre demeure et empêche les remontées dans le tube 14 vers le volume 2.

La partie inférieure de la paroi 4 se rétrécit juste au dessus de l'orifice du tube 3 et se termine par une partie de diamètre plus faible. Ceci à pour but de faciliter l'éclatement de bulles remontant vers le volume 1 dans le cas où, par suite d'un incident, une surpression serait présente du côté de la sortie.

Enfin le dispositif 1-9 est suivi d'un deuxième dispositif de constructions voisines 10-13. Ce deuxième dispositif ne comporte pas de communication 8 munie d'un étranglement 7 entre les deux volumes référencés ici 10 et 20, correspondant respectivement aux volumes 1 et 2 dans le dispositif de gauche.

En outre le niveau du liquide est ajusté plus bas que dans le dispositif de gauche de façon que le tube 11 débouche en permamence au-dessus du liquide.

Le volume 10 communique avec la sortie "ex" vers la colonne de lavage, et le volume 20 communique avec l'air libre extérieur par l'orifice 13. Dans le cas où l'entrée de la colonne de lavage serait bouchée et rendrait donc impossible un débit par l'orifice "ex", le gaz pourrait néanmoins s'échapper par l'orifice 13 en faisant des bulles dans le liquide, et évitant ainsi une trop forte surpression dans la canalisation 14 et un blocage du débit du fluide dans le dispositif de gauche.

## Revendications

1. Système antiretour de fluide comportant un dispositif constitué par une enceinte contenant un liquide inerte vis à vis dudit fluide, un tube d'arrivée de fluide dont l'extrémité, en l'absence de débit de fluide, plonge dans le liquide, et un tube de départ de fluide puisant le fluide dans l'enceinte au-dessus du niveau du liquide, caractérisé en ce que l'enceinte est munie d'une paroi interne (4) possédant un bord libre inférieur qui plonge dans le liquide plus profondément que l'extrémité du tube d'arrivée (3), et sépare ainsi deux volumes tels que le premier (1) contient l'extrémité du tube d'arrivée alors que le second (2) en est séparé par la paroi, en ce que ces deux volumes communiquent entre eux via un organe (7) provoquant une perte de charge lors d'un débit de fluide, et en ce que le tube de sortie (14) communique directement avec le second volume, de façon que, pour un débit approprié de fluide, le niveau du liquide descende dans le premier volume en-dessous de l'extrémité du tube d'arrivée, tout en restant au-dessus du bord libre de la paroi.

2. Système selon la revendication 1, caractérisé en ce que l'organe (7) provoquant une perte de charge est réglable, en ce qui concerne la perte de charge.

3. Système selon l'une des revendication 1 ou 2, caractérisé en ce que le tube de sortie (14) est muni d'une prise pour y injecter un gaz neutre.

4. Système selon l'une quelconque des revendications 1 à 3, caractérisé en ce que la paroi interne (4) est cylindrique et entoure le tube d'arrivée.

5. Système selon la revendication 4, caractérisé en ce que la partie de la paroi interne cylindrique voisine du bord libre se rétrécit et se termine par une partie de diamètre plus faible au niveau du bord libre.

6. Système selon l'une quelconque des revendications précédentes, caractérisé en ce qu'il est connecté entre la sortie des gaz réactants d'un réacteur d'épitaxie et l'entrée d'une colonne de lavage des gaz.

7. Système selon la revendication 6, caractérisé en ce que l'enceinte et la paroi sont réalisées en verre pyrex.

8. Système selon l'une des revendication 6 ou 7, caractérisé en ce que le liquide est de l'huile de vaseline.

9. Système antiretour selon l'une quelconque des revendications 6 à 8, caractérisé en ce qu'il comporte en aval dudit dispositif un deuxième dispositif, constitué par une enceinte contenant un liquide inerte vis à vis dudit fluide, avec un tube d'arrivée de fluide (11) dont l'extrémité est située juste au dessus de la surface du liquide, enceinte munie d'une paroi interne (12) possédant un bord libre inférieur qui plonge dans le liquide et sépare ainsi deux volumes tels que le premier contient l'extrémité du tube d'arrivée alors que le second en est séparé par la paroi, un tube puisant le fluide dans le premier volume pour l'amener à la colonne de lavage, alors que le deuxième volume est mis en communication avec l'air libre extérieur.

FIG. 1

FIG. 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | FR-A-1 407 149  (INSTITUT DE RECHERCHE)<br>* En entier *<br>--- | 1,4 | F 16 K    9/00<br>F 16 K   15/00<br>C 30 B   25/14 |
| A | US-A-1 910 012  (HALSEY)<br>* Page 1, lignes 28-50; page 2, lignes 54-66; figure 1 *<br>--- | 1,2 | |
| A | FR-A-2 342 439  (JOHN ZINK)<br>* Page 3, ligne 27 - page 4, ligne 23; figures 1,6 *<br>--- | 1 | |
| A | EP-A-0 122 194  (ROUQUETTE)<br>* Figures 1,2 *<br>----- | 1 | |

DOMAINES TECHNIQUES
RECHERCHES (Int. Cl.5)

F 16 K
C 30 B

Le présent rapport a été établi pour toutes les revendications

| Lieu de la recherche | Date d'achèvement de la recherche | Examinateur |
|---|---|---|
| LA HAYE | 06-11-1989 | FONSECA Y FERNANDEZ H. |